Europäisches Patentamt

European Patent Office

Office européen des brevets

(19)

(11) EP 1 725 087 A1

(12) EUROPEAN PATENT APPLICATION

(43) Date of publication:
22.11.2006 Bulletin 2006/47

(51) Int Cl.:
H05K 3/34 (2006.01)   B23K 35/02 (2006.01)

(21) Application number: 06075962.8

(22) Date of filing: 28.04.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 16.05.2005 US 129984

(71) Applicant: Delphi Technologies, Inc.
Troy, Michigan 48007 (US)

(72) Inventors:
• Kuhlman, Frederick F.
Kokomo, IN 46902 (US)

• Carter, Bradley H.
Kokomo, IN 46902 (US)
• Parker, Richard D.
Tipton, IN 46072 (US)
• Yeh, Shing
Kokomo, IN 46902 (US)

(74) Representative: Denton, Michael John et al
Delphi European Headquarters,
64 avenue de la Plaine de France,
Paris Nord II,
B.P. 65059, Tremblay en France
95972 Roissy Charles de Gaulle Cedex (FR)

(54) **Electronic assembly with controlled metal particle-containing solder joint thickness**

(57)     An electronic assembly (200,400,400A) includes a bare IC die or a leadless electronic component (406A) having at least one electrically conductive contact formed on a surface of the die (106,406) or the component (406A) and a leadframe (102) or a substrate (402,402A) having at least one electrically conductive trace. The conductive contact of the component (406A) is electrically and mechanically coupled to the conductive trace with a solder joint (108,408). The solder joint (108,408) includes a plurality of solid electrically conductive metal particles (110,410) having a substantially spherical shape and a diameter ranging from about one mil to about ten mils.

## Fig.3.

**Description**

<u>Technical Field</u>

The present invention is generally directed to an electronic assembly and, more specifically, to an electronic assembly with controlled solder joint thickness.

<u>Background of the Invention</u>

Traditionally, lead-bearing solder alloys have been widely utilized in the electronics industry, due to manufacturability, reliability and generally lower cost of electronic assemblies that have utilized lead-bearing solder alloys. Today, due to environmental concerns, various organizations are advocating for the elimination of lead-bearing solder alloys in electronic assemblies. Potential lead-free replacements are tin-based lead-free alloys that include tin/silver, tin/copper, tin/antimony, tin/bismuth and tin/silver/copper. As is well known to one of ordinary skill in the art, solder joints provide electrical and mechanical connections between various electronic components, e.g., integrated circuits (ICs), and their associated substrates or leadframes. In general, a key reliability characteristic of a solder joint is its fatigue resistance, which is a function of the solder alloy utilized, the substrate or leadframe material utilized, the dimensions of the electronic components utilized, the temperature excursion experienced and the solder joint thickness achieved.

In general, the relationship of an electronic assembly that includes a leadframe substrate and a bare IC die may be defined by the Coffin-Manson low-cycle fatigue model, which is set forth below:

$$\overline{N}_f = \frac{1}{2}\left(\frac{\Delta\gamma}{2\varepsilon'_f}\right)^{\frac{1}{c}}$$

$$\Delta\gamma = \frac{L_e}{h}\left|(\Delta\alpha)*(\Delta T)\right|$$

$$\overline{N}_f \propto \left(\frac{h}{L_e}\right)^2$$

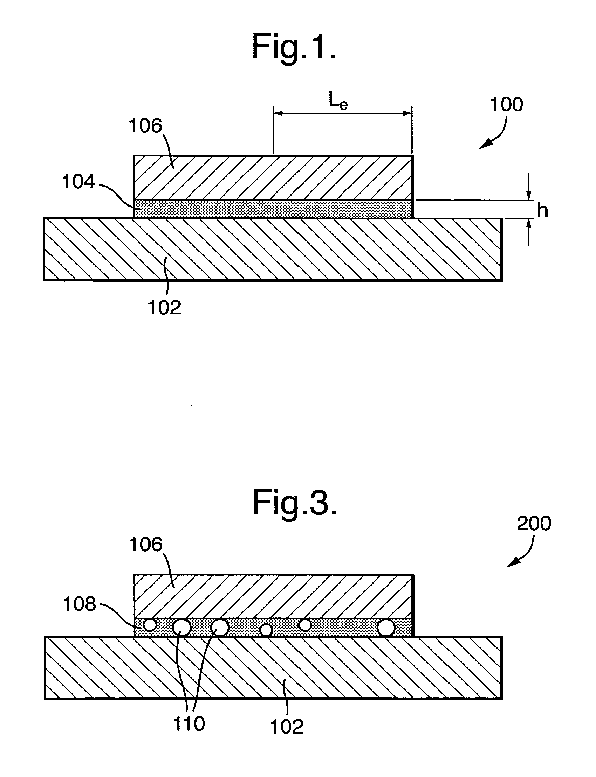

where $\overline{N}_f$ is equal to the median fatigue life of a solder joint in cycles, $\Delta\gamma$ is the applied cycle shear strain range due to IC-substrate coefficient of thermal expansion (CTE) mismatch, $\varepsilon'_f$ is the fatigue ductility coefficient ($2\varepsilon'_f \cong 0.65$ for common solder alloys), c is the fatigue ductility exponent ($c \cong -0.5$ for IC die bond), h is the solder joint height (or the IC solder die bond thickness) and $L_e$ is the effective half length of the integrated circuit (IC) die. As the above formulas indicate, the solder joint thermal fatigue life is a function of the IC die size ($L_e$), the solder joint thickness (h), the thermal mismatch between the IC and the substrate ($\Delta\alpha$), the temperature excursion range ($\Delta T$) and the solder material properties (see Fig. 1, which depicts an electronic assembly 100 that includes an IC die 106 that is coupled to a leadframe 102 by a solder joint ( or a solder IC die bond) 104).

As is evident from the examination of the above equations, the thermal fatigue life of a solder joint increases approximately with the square of the IC solder die bond thickness. In general, lead-bearing alloys have better thermal fatigue resistance than tin-based lead-free alloys. Thus, it is even more desirable to maintain an adequate solder joint thickness in order to overcome the weakness of a lead-free solder joint. Typically, solder joint thickness has been addressed by controlling the size of a solderable area, solder quantity, utilizing a solder dam, controlling process temperatures, using special tools, etc. In general, these approaches have either been ineffective, hard to apply or cost prohibitive.

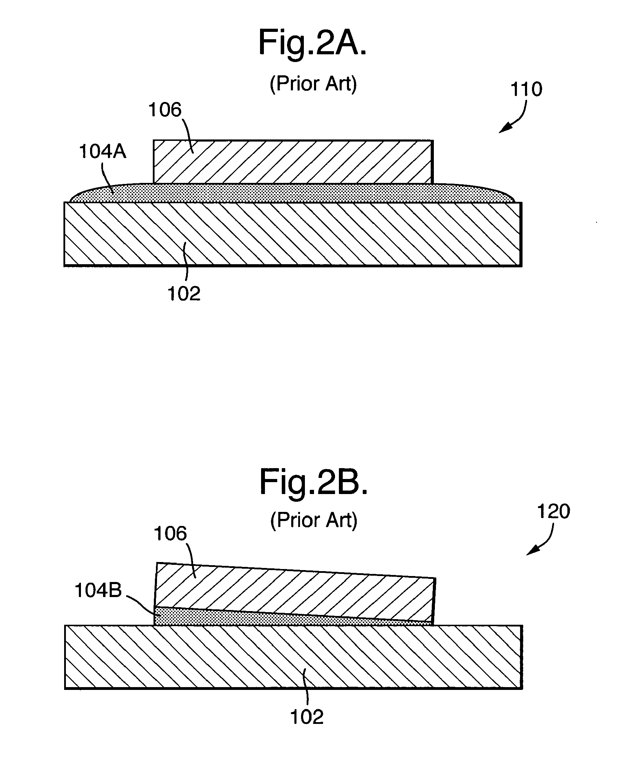

Fig. 2A depicts an electronic assembly 110 that includes an IC die 106 coupled to a leadframe 102, with a defective thin solder joint 104A. Fig. 2B shows an electronic assembly 120 that includes an IC die 106 mounted to the leadframe 102, with a defective tilted solder joint 104B. From the above discussion, it should be appreciated that thin solder joints and tilted solder joints decrease the reliability of an associated electronic assembly.

What is needed is a technique for coupling an integrated circuit (IC) die to a substrate or leadframe that provides a relatively uniform solder joint thickness, thus, avoiding thin and tilted solder joints and other solder joint defects. This concept can also be extended to other surface mount devices (SMD), including leadless and leaded devices on circuit boards.

## Summary of the Invention

One embodiment of the present invention is directed to an electronic assembly that includes a bare IC die or a leadless electronic component having at least one electrically conductive contact, formed on a surface of the component. The assembly also includes a substrate or a leadframe having at least one electrically conductive trace. The conductive contact of the component is electrically coupled to the conductive trace with a solder joint. The solder joint includes a plurality of solid electrically conductive metal particles having a substantially spherical shape and a diameter ranging from about one mil to about ten mils. According to another aspect of the present invention, the particles are made of copper or nickel.

According to a different aspect of the present invention, the solder joint has a thickness ranging between about two mils and about four mils and the particles have a diameter of about two mils. According to this aspect of the present invention, the particles may be made of copper or nickel. According to another aspect of the present invention, the solder joint is made of a lead-free tin-based solder alloy. According to a different embodiment, the particles have a higher melting point than the solder, and do not dissolve into a molten solder used to form the solder joint during a solder reflow process. According to another aspect, the particles have a density higher than or equal to a density of the solder. According to yet another aspect, the particles have a mesh size between -150 and +325. According to this embodiment, the particles are made of copper or nickel and the solder joint is made of a tin-based solder alloy. According to another aspect of the present invention, the tin-based solder may be about sixty-three percent tin and about thirty-seven percent lead by weight. According to a different aspect of the present invention, the tin-based solder is a lead-free solder, which may be an alloy containing a eutectic or near eutectic composition of tin/silver/copper, tin/silver, or tin/copper alloy.

According to another aspect of the present invention, the leadless electronic component is one of a chip resistor, a chip capacitor, a packaged integrated circuit (IC), or a bare IC die.

These and other features, advantages and objects of the present invention will be further understood and appreciated by those skilled in the art by reference to the following specification, claims and appended drawings.

## Brief Description of the Drawings

The present invention will now be described, by way of example, with reference to the accompanying drawings, in which:

Fig. 1 is a cross-sectional view of a relevant portion of an exemplary electronic assembly, including an integrated circuit (IC) die mounted to a leadframe;

Figs. 2A-2B are cross-sectional views of a relevant portion of exemplary electronic assemblies, including an IC die mounted to a leadframe, and experiencing certain defects according to the prior art;

Fig. 3 is a cross-sectional view of a relevant portion of an electronic assembly, constructed according to one embodiment of the present invention;

Fig. 4 is a cross-sectional view of a relevant portion of an exemplary electronic assembly, including a leadless packaged IC, such as micro leadframe (MLF) or quad flat pack no lead (QFN), mounted to a substrate, according to another embodiment the present invention; and

Fig. 5 is a cross-sectional view of a relevant portion of an exemplary electronic assembly, including a leadless electronic component, such as a chip resistor or chip capacitor, mounted to a substrate, according to another embodiment of the present invention.

## Description of the Preferred Embodiments

According to one embodiment of the present invention, solid conductive metal particles, e.g., copper or nickel particles, which may be substantially spherical, are added to a solder paste to achieve a desired solder joint that is not tilted or thinned and has a desired thickness. According to this embodiment, an electronic assembly may then achieve a desired reliability and meet thermal cycling requirements in field applications. During the assembly process, when the solder paste is reflowed to electrically and mechanically couple one or more conductive contacts of a bare IC die or a leadless electronic component, e.g., a leadless integrated circuit (IC) package, chip capacitor, chip resistor, etc., to one or more conductive traces, which are a part of a leadframe or are formed on a substrate, the presence of the metal particles in the molten solder prevent the solder joint from collapsing and, as such, maintain a desired solder joint thickness. This is particularly desirable when the electronic component is a leadless component as associated solder joints provide stand-off between the component and its leadframe or substrate, as well as providing compliance.

It should be appreciated that other metals may be used in the production of the solid metal particles, providing the metals utilized wet to solder, have a density equivalent or higher than the molten solder, and do not melt or dissolve into the molten solder at temperatures experienced during the solder reflow process. The present invention is broadly applicable to electronic assemblies employing various leadless IC packages, e.g., micro leadframe (MLF), quad flat-pack no lead (QFN), power QFN, land grid array (LGA), and leadless chip carrier (LCC), as well as surface mount technology (SMT) leadless discrete components.

As noted above, according to one embodiment of the present invention, solid conductive metal particles, e.g., copper or nickel particles, which may be spheres, are added to a solder paste to achieve a desired solder joint thickness and minimize tilting. According to this embodiment, an electronic assembly is designed to meet desired reliability and thermal cycling criteria. During the assembly process, when solder paste is reflowed to electrically and mechanically couple an integrated circuit (IC) die to a leadframe, the presence of the metal, e.g., copper or nickel, particles in the solder paste prevent the solder joint from collapsing, while maintaining a desirable solder joint thickness.

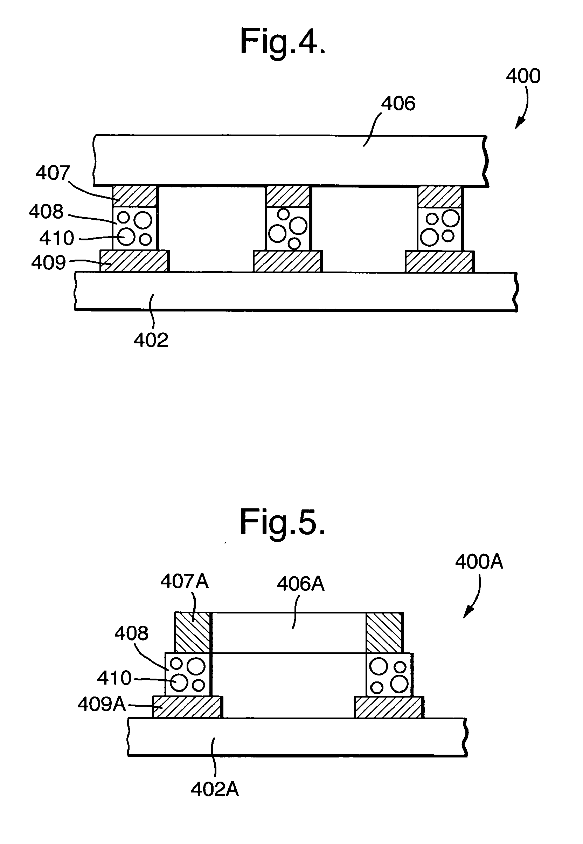

With reference to Fig. 3, an electronic assembly 200 includes an integrated circuit (IC) die 106 coupled to a leadframe 102, with a solder die bond 108 that includes a plurality of metal spheres 110. The size of the spheres 110 may be in a range of about one to ten mils in diameter, depending upon a desired solder joint thickness, die size, solder stencil thickness, etc. In a typical application, a desired solder joint thickness is usually about two mils to about four mils.

With reference to Fig. 4, an assembly 400 includes leadless integrated circuit (IC) package 406, whose electrically conductive contacts 407 are electrically coupled to electrically conductive traces 409 formed on a substrate 402, with a solder joint 408 that includes a plurality of metal particles 410. The size of the particles 410 may be in a range of one to ten mils in diameter, depending upon the desired solder joint thickness, the die size, the solder stencil thickness, etc. More particularly, the metal particles may have a size between about -200 to +325 mesh, i.e., about 2.9 mils to 1.7 mils. A desired thickness of the solder joint is usually about four mils, with a minimum thickness of about two mils.

As is shown in Fig. 5, an assembly 400A includes a leadless discrete component 406A, e.g., a chip resistor or a chip capacitor, whose electrically conductive contacts 407A are electrically coupled to conductive traces 409A formed on a substrate 402A, with a solder joint 408 that includes a plurality of metal particles 410. As above, the size of the particles 410 may be in a variety of ranges, depending upon the desired solder joint thickness, the component size, the solder stencil thickness, etc.

A number of experiments were initiated to determine the effectiveness of implementing metal particles, having a size of between about - 150 to +325 mesh in a solder paste to provide a reliable solder joint thickness. As is shown in the Table 1 below, lead-free die bonds with copper particles had an average solder thickness of about 4.3 mils and a minimum thickness of about 2.5 mils. Die bonds without the copper particles had an average solder thickness of about 2.8 mils and a minimum thickness of about 0.7 mils. The tin-lead die bond also shows the same trend, with increasing average solder thickness and lower solder thickness variation, when the copper particles were added to a tin-lead solder paste. According to the Coffin-Manson low-cycle fatigue model, the thermal fatigue life of a solder joint with copper spheres is expected to be at least two-and-a-half times of that of a solder joint without copper spheres.

Table 1: Solder Joint Thickness

|  | Pb-free Alloy | Pb-free Alloy | SnPb Alloy | SnPb Alloy |
|---|---|---|---|---|
| Cu Sphere | Yes | No | Yes | No |
| Average | 4.3 mil | 2.8 mil | 3.7 mil | 1.7 mil |
| St. Dev. | 1.0 mil | 1.4 mil | 0.4 mil | 1.0 mil |
| Minimum | 2.5 mil | 0.7 mil | 2.6 mil | 0.2 mil |
| Maximum | 5.8 mil | 5.7 mil | 4.4 mil | 4.3 mil |

Accordingly, techniques have been disclosed herein, which utilize metal particles in a solder paste to electrically connect an IC die or other leadless electronic component to a leadframe or a substrate. Electronic assemblies so constructed are advantageous in that reliability of the electronic assemblies is increased.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

**Claims**

1. An electronic assembly (200,400,400A), comprising:

   an integrated circuit (IC) die (106,406) or a leadless electronic component (406A) including at least one electrically conductive contact formed on a surface of the die (106,406) or the component (406A); and
   an electrically conductive leadframe (102) or a substrate (402,402A) having at least one electrically conductive trace, wherein the conductive contact of the IC die (106,406) or the component (406A) is electrically and mechanically coupled to the conductive trace with a solder joint (108,408), and wherein the solder joint (108,408) includes a plurality of solid electrically conductive metal particles (110,410) having a substantially spherical shape and a diameter ranging from about one mil to about ten mils.

2. The assembly (200,400,400A) of claim 1, wherein the metal particles (110,410) are made of copper or nickel.

3. The assembly (200,400,400A) of claim 1, wherein the solder joint (108,408) is made of a lead-free solder alloy having a thickness ranging between about two mils and about four mils, and wherein the metal particles (110,410) have a diameter of about two to four mils.

4. The assembly (200,400,400A) of claim 3, wherein the metal particles (110,410) are made of copper or nickel.

5. The assembly (200,400,400A) of claim 1, wherein the solder joint (108,408) is made of a lead-free tin-based solder.

6. The assembly (200,400,400A) of claim 1, wherein the metal particles (110,410) have a higher melting point than a solder used to form the solder joint (108,408) and do not appreciably dissolve into the solder when molten during a solder reflow process.

7. The assembly (200,400,400A) of claim 6, wherein the metal particles (110,410) have a density higher than or equal to a density of the solder.

8. The assembly (200,400,400A) of claim 6, wherein the metal particles (110,410) have a mesh size between -150 and +325, and wherein the metal particles (110,410) are made of copper or nickel, and where the solder is a tin-based solder.

9. The assembly (200,400,400A) of claim 8, wherein the tin-based solder is about sixty-three percent tin and about thirty-seven percent lead.

10. The assembly (200,400,400A) of claim 8, wherein the tin-based solder is made of a lead-free solder.

11. The assembly (200,400,400A) of claim 10, wherein the lead-free solder is an alloy containing a eutectic or near eutectic composition of tin/silver/copper, tin/silver, or tin/copper alloy.

12. The assembly (200,400,400A) of claim 1, wherein the leadless electronic component (406A) is one of a chip resistor and a chip capacitor.

13. The assembly (200,400,400A) of claim 1, wherein the IC die (106) is a bare integrated circuit (IC) die.

14. An electronic assembly (200,400,400A), comprising:

   an integrated circuit (IC) die (106,406) or a leadless electronic component (406A) including at least one electrically conductive contact formed on a surface of the die (106,406) or the component (406A); and
   an electrically conductive leadframe (102) or a substrate (402,402A) having at least one electrically conductive trace, wherein the conductive contact of the IC die (106,406) or the component (406A) is electrically and mechanically coupled to the conductive trace with a solder joint (108,408), and wherein the solder joint (108,408) includes a plurality of solid electrically conductive metal particles (110,410) having a substantially spherical shape and a diameter ranging from about one mil to about ten mils, where the solder joint (108,408) is made of a lead-free tin-based solder.

15. The assembly (200,400,400A) of claim 14, wherein the metal particles (110,410) are made of copper, nickel or other solder wettable alloy that does not appreciably dissolve into a molten solder used to form the solder joint during a solder reflow process.

16. The assembly (200,400,400A) of claim 14, wherein the metal particles (110,410) have a higher melting point than the solder and do not dissolve into a molten solder used to form the solder joint during a solder reflow process and the metal particles (110,410) have a density higher than or equal to a density of the solder.

17. The assembly (200,400,400A) of claim 14, wherein the metal particles (110,410) have a mesh size between -150 and +325, and wherein the metal particles (110,410) are made of copper, nickel or other solder wettable alloy that does not appreciably dissolve into a molten solder used to form the solder joint during a solder reflow process.

18. The assembly (200,400,400A) of claim 14, wherein the tin-based solder is an alloy containing a eutectic or near eutectic composition of tin/silver/copper, tin/silver, or tin/cooper alloy.

19. The assembly (200,400,400A) of claim 14, wherein the leadless electronic component (406A) is one of a chip resistor, a chip capacitor, a packaged integrated circuit (IC), or a bare IC die.

20. An electronic assembly (200,400,400A), comprising:

an IC die (106,406) or a leadless electronic component (406A) including at least one electrically conductive contact formed on a surface of the die (106,406) or the component (406A); and
an electrically conductive leadframe (102) or a substrate (402,402A) having at least one electrically conductive trace, wherein the conductive contact of the component (406A) is electrically and mechanically coupled to the conductive trace with a lead-free solder joint (108,408), and wherein the solder joint (108,408) includes a plurality of solid electrically conductive metal particles (110,410) having a substantially spherical shape, and wherein the metal particles (110,410) have a mesh size between -150 and +325 and the metal particles (110,410) are made of copper or nickel.

# Fig.1.

# Fig.3.

# Fig.2A.

(Prior Art)

# Fig.2B.

(Prior Art)

# Fig.4.

# Fig.5.

**European Patent Office**

## EUROPEAN SEARCH REPORT

Application Number

EP 06 07 5962

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/134976 A1 (KEYSER FRANK ET AL) 15 July 2004 (2004-07-15) * abstract * * figures 1,3,4 * * paragraphs [0001], [0002], [0020] - [0023], [0025], [0027] * ----- | 1-20 | INV. H05K3/34 B23K35/02 |
| X | US 2005/093164 A1 (STANDING MARTIN) 5 May 2005 (2005-05-05) * paragraphs [0003], [0034], [0036] - [0039], [0042], [0045], [0047], [0050] - [0056] * * figures 3,7-9 * ----- | 1-20 | |
| X | US 2005/092819 A1 (LIU YAN ET AL) 5 May 2005 (2005-05-05) * figures 1-4 * * paragraphs [0011], [0034], [0035], [0038], [0039], [0050] - [0053] * ----- | 1-20 | |
| X | PATENT ABSTRACTS OF JAPAN vol. 015, no. 190 (M-1113), 16 May 1991 (1991-05-16) -& JP 03 047693 A (TAMURA SEISAKUSHO CO LTD), 28 February 1991 (1991-02-28) * abstract; figure 2 * ----- | 1,6,13 | TECHNICAL FIELDS SEARCHED (IPC) H05K |
| A | US 5 527 628 A (ANDERSON ET AL) 18 June 1996 (1996-06-18) * abstract * ----- | 11,18 | |
| A | US 2004/112478 A1 (BIELER THOMAS R ET AL) 17 June 2004 (2004-06-17) * paragraph [0028] * ----- | 11,18 | |

The present search report has been drawn up for all claims

| Place of search | Date of completion of the search | Examiner |
|---|---|---|
| Munich | 20 July 2006 | Crampin, N |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 725 087 A1**

**ANNEX TO THE EUROPEAN SEARCH REPORT
ON EUROPEAN PATENT APPLICATION NO.**

EP 06 07 5962

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2006

| Patent document cited in search report | | Publication date | Patent family member(s) | | Publication date |
|---|---|---|---|---|---|
| US 2004134976 | A1 | 15-07-2004 | WO | 2004065050 A2 | 05-08-2004 |
| US 2005093164 | A1 | 05-05-2005 | EP<br>WO | 1678759 A2<br>2005041265 A2 | 12-07-2006<br>06-05-2005 |
| US 2005092819 | A1 | 05-05-2005 | WO | 2005042203 A1 | 12-05-2005 |
| JP 03047693 | A | 28-02-1991 | NONE | | |
| US 5527628 | A | 18-06-1996 | NONE | | |
| US 2004112478 | A1 | 17-06-2004 | NONE | | |

EPO FORM P0459

For more details about this annex : see Official Journal of the European Patent Office, No. 12/82